# FASCICULE DE BREVET EUROPEEN

(11) **EP 4 591 431 B1**
(45) Date de publication et mention de la délivrance du brevet: **18.11.2026**
(21) Numéro de dépôt: 23767924.6
(22) Date de dépôt: 14.09.2023
(51) Int. Cl.: H02S 50/10

(54) **PROCÉDÉ DE TEST D'AU MOINS UNE DIODE DE DÉRIVATION SUR UNE INSTALLATION COMPORTANT AU MOINS UN MODULE PHOTOVOLTAÏQUE EN FONCTIONNEMENT**
VERFAHREN ZUM TESTEN MINDESTENS EINER BYPASSDIODE IN EINER VORRICHTUNG MIT MINDESTENS EINEM IM BETRIEB BEFINDLICHEN FOTOVOLTAISCHEN MODUL
METHOD FOR TESTING AT LEAST ONE BYPASS DIODE IN AN APPARATUS COMPRISING AT LEAST ONE PHOTOVOLTAIC MODULE IN OPERATION

(30) Priorité: 21.09.2022 FR 2209577
(43) Date de publication de la demande: 30.07.2025
(73) Titulaire: Electricité de France, 75008 Paris (FR)
(72) Inventeur: DUPUIS, Julien, 77590 BOIS LE ROI (FR); ACHARD, Valentin, 91120 PALAISEAU (FR)
(74) Mandataire: Plasseraud IP
(86) Numéro de dépôt international: PCT/EP2023/075217
(87) Numéro de publication internationale: WO 2024/061714

(56) Documents cités:
- EP-A1- 3 306 815
- CN-A- 113 765 480

## Description

### Domaine technique

La présente divulgation relève du domaine des modules photovoltaïques ou panneaux solaires, et concerne en particulier un procédé de test d'au moins une diode de dérivation sur une installation comportant au moins un module photovoltaïque en fonctionnement ainsi qu'un dispositif pour mettre en œuvre un tel procédé.

### Technique antérieure

Les diodes de dérivation, connues sous le nom de diodes « bypass », sont des composants électroniques qui, placés en dérivation des chaînes (encore appelées « strings » en anglais) de cellules photovoltaïques, permettent, en cas de défaillance d'une cellule, de limiter les pertes de production du module photovoltaïque. Le document EP 3 306 815 A1 est relevant.

Le principe de l'utilisation de ces diodes de dérivation est décrit ci-après.

Dans un module photovoltaïque comportant une pluralité de cellules photovoltaïques, une cellule partiellement ombragée conduit à créer une perte en courant. Pour les objets complètement opaques comme une feuille, la baisse de courant de sortie de la cellule sera proportionnelle à la surface de la cellule qui a été obscurcie.

Lorsqu'une chaîne de cellules en série est proche du court-circuit, alors la tension de polarisation directe de l'ensemble des cellules va polariser en inverse la cellule ombragée qui fonctionnera en récepteur. On obtient un phénomène dit de points chauds lorsqu'un grand nombre de cellules connectées en série provoque une polarisation inverse à travers la cellule ombragée, conduisant à la dissipation d'une forte puissance dans la cellule ombragée. Cette grande dissipation de puissance survenant dans une cellule unique va conduire à une zone d'échauffement localisée qui peut entraîner la destruction au moins de cette cellule, et perturber les performances du module en entier.

Les effets destructeurs d'un point chaud peuvent être contournés par l'utilisation d'une diode de dérivation. Si une cellule solaire est polarisée en inverse en raison d'un déséquilibre en courant entre plusieurs cellules connectées en série, alors la diode de dérivation va devenir passante, permettant ainsi au courant de circuler dans le circuit externe passant par la diode de dérivation.

En pratique, placer une diode de dérivation pour chaque cellule est trop coûteux et non aisé à réaliser. Ainsi, les diodes de dérivation sont généralement placées sur des chaînes de cellules. Chaque chaîne comporte par exemple entre dix-huit et vingt-six cellules. Chaque module comporte généralement trois chaînes de cellules et trois diodes de dérivation associées respectivement à chaque chaîne de cellules.

Le diagnostic de l'état de fonctionnement des diodes de dérivation est important pour maximiser la production des modules photovoltaïques.

En effet, il existe deux modes de défaillance pour une diode de dérivation, à savoir le court-circuit et le circuit ouvert. Dans le premier cas, une défaillance de la diode de dérivation liée à un dysfonctionnement d'une ou plusieurs cellules photovoltaïques, à cause d'un ombrage, d'un court-circuit, entre autres, entraîne une perte de production du module photovoltaïque. Dans le deuxième cas, une défaillance en circuit ouvert peut entraîner dans le cas le plus défavorable une perte totale de la puissance du panneau.

Il est connu de caractériser de manière automatique le fonctionnement des diodes de dérivation. On connaît en particulier une détection électrique par utilisation des courbes Intensité/tension (I/V), de la puissance fournie par les modules. Une autre technique consiste en une détection numérique par apprentissage automatique (« machine learning » en anglais, logique floue pour « fuzzy logic » en anglais). Une troisième technique connue est une détection statistique mettant en œuvre un test hypothétique statistique encore appelé T-test.

De telles techniques sont toutes basées sur l'analyse des courbes de production du module photovoltaïque. Cette analyse est complexe à mettre en œuvre sur une chaîne de modules où les courbes I/V de plusieurs modules photovoltaïques se combinent.

De plus, lorsque la diode de dérivation est défectueuse et reste en mode passant, la détection de ce défaut n'est pas certaine car les inspections de type électrique sur les installations solaires sont souvent globales.

Par ailleurs, lorsque la diode de dérivation est défectueuse et reste, en fonctionnement, fermée, elle ne sera pas détectée comme défectueuse en l'absence d'un défaut supplémentaire sur le module photovoltaïque car ce dernier fonctionnera normalement. Cependant, en cas de défaut ou d'ombrage partiel ou permanent, la diode défectueuse ne jouera pas son rôle de protection et les cellules photovoltaïques du module, ombragées, risquent d'avoir une température de plusieurs centaines de degrés celsius, risquant de compromettre l'intégrité du module photovoltaïque, voire, dans des cas extrêmes, de provoquer un incendie.

De surcroît, aucune technique ne permet de tester complètement le fonctionnement d'une diode de dérivation lorsque le module photovoltaïque est en fonctionnement dans une centrale ou installation photovoltaïque. Par exemple, on peut utiliser des caméras infrarouges par drones ou avion mais on ne verra pas les diodes qui restent bloquées en mode ouvert.

Il existe ainsi un besoin de disposer d'un test d'au moins une diode de dérivation sur une installation comportant au moins un module photovoltaïque en fonctionnement.

### Résumé

La présente divulgation vient améliorer la situation.

Il est proposé un procédé de test d'au moins une diode de dérivation sur une installation photovoltaïque comportant au moins un module photovoltaïque en fonctionnement, ledit module photovoltaïque comportant au moins une chaîne de cellules photovoltaïques reliées à une diode de dérivation dédiée à ladite chaîne, le procédé comportant:
a. ombrager une partie des cellules de ladite chaîne de manière à provoquer une mise en dérivation au travers de ladite diode, ladite mise en dérivation provoquant une augmentation de température de la diode si la diode est dans un état fonctionnel;
b. mesurer au moins une température de la diode et
c. comparer la température mesurée à un seuil pour déduire un état de ladite diode.

On entend par « un état de la diode » au moins le fait qu'elle fonctionne ou non. Ainsi, « l'état fonctionnel de la diode » peut désigner *a minima* le fait que la diode fonctionne et peut être utilisée dans le module. On peut, de façon plus fine, caractériser son fonctionnement en relevant précisément sa température ou une variation de sa température par exemple.

La notion de « seuil » est générale. Il peut s'agir de la mesure de la température de la diode à un autre instant (qui précède par exemple le moment de la mise en dérivation), ou encore, par exemple la mesure de température d'un autre élément, comme le module photovoltaïque lui-même ou la température de la chaîne de cellules auquel est rattachée la diode testée, ou d'une zone connexe à la diode, ou encore d'une température fixe comme la température ambiante (par exemple 25°C).

L'activation de la diode, si elle est en état fonctionnel, va générer un échauffement local qui sera détecté grâce à la mesure de la température et caractérisé par la comparaison audit seuil.

Si la diode n'est pas en état fonctionnel, on ne pourra pas observer de variation de température à son niveau.

Si l'on mesure la température de la diode dans le moment précédant la mise en dérivation, laquelle est l'instant où elle devient passante, et si cette température constituant ledit seuil est sensiblement égale à la température ambiante et qu'on n'observe pas de variation de la température de la diode après mise en dérivation, alors on peut en conclure que la diode est défectueuse, étant bloquée en circuit ouvert.

Si l'on compare la température de la diode, mesurée après mise en dérivation, au seuil correspondant à la température de la diode mesurée dans le moment précédant la mise en dérivation, et si cette dernière température constituant le seuil est supérieure à la température ambiante et qu'on n'observe pas de variation de la température de la diode après mise en dérivation, alors on peut en conclure que la diode est défectueuse, étant bloquée en court-circuit.

La température de la diode peut être la température de la diode elle-même, de la chaîne dans laquelle elle se trouve, voire du module.

La détection d'une ou de plusieurs diodes défectueuses peut permettre de prévenir d'éventuels risques de sécurité et/ou d'améliorer la production électrique de l'installation lorsqu'elle comporte une pluralité de modules photovoltaïques. De plus, d'autres défauts connexes tels qu'une ou des cellules photovoltaïques défectueuses peuvent être détectés à l'aide du procédé selon l'invention, notamment par la prise de mesures de températures.

L'étape b est mise en œuvre après l'étape a.

Le module photovoltaïque comporte avantageusement des cellules pouvant être choisies dans le groupe constitué par des demi-cellules, des cellules pleines, des cellules dites « shingles » (« bardeaux » en français), coupées en cinq ou six, et des cellules fabriquées en couches minces tel que, par exemple en cadmium tellure (CdTe), à base de cuivre, de gallium, d'indium et de sélénium CIGS, à base d'Arsenlure de Gallium GaAs, etc.

L'installation comporte avantageusement plusieurs modules photovoltaïques disposés côte à côte deux à deux et comportant chacun une pluralité de chaînes comportant chacune une pluralité de cellules et reliées chacune à une diode de dérivation.

Les caractéristiques exposées dans les paragraphes suivants peuvent, optionnellement, être mises en œuvre, indépendamment les unes des autres ou en combinaison les unes avec les autres :

Lorsque le module photovoltaïque comporte plusieurs chaînes de cellules et plusieurs diodes associées auxdites chaînes, la mise en dérivation peut être provoquée par l'ombrage partiel pour plusieurs chaînes, auquel cas plusieurs diodes sont activées simultanément, et leur état peut être testé simultanément à l'aide du procédé selon l'invention.

Le procédé peut être mis en œuvre sur plusieurs modules photovoltaïques adjacents. L'étape a peut être mise en œuvre sur plusieurs chaînes de cellules simultanément, voire pour plusieurs modules photovoltaïques, en fonction de la configuration de l'ensemble, appelé stand, de modules photovoltaïques, ce qui peut provoquer la mise en dérivation simultanée de plusieurs chaînes au sein d'un même module photovoltaïque et/ou de plusieurs chaînes réparties sur différents modules photovoltaïques, par exemple disposés côte-à-côte deux à deux.

Au moins les étapes a et b sont de préférence mises en œuvre à l'aide d'un robot, notamment d'un robot nettoyeur de module photovoltaïque. Pour ce faire, ledit robot est avantageusement configuré pour ombrager ladite partie des cellules. Le robot comporte de préférence un capteur thermique, notamment une caméra thermique, pour mesurer ladite au moins une température de la diode. Le robot est de préférence fixé sur le module ou l'installation photovoltaïque et mobile en translation relativement à celui-ci ou celle-ci selon une direction d'avancement.

Le procédé peut utiliser, selon ce mode de réalisation, le robot nettoyeur, par exemple présent de fait sur l'installation comportant le ou les modules photovoltaïques, pour ombrager une partie des cellules, mais un autre robot ou un autre équipement, ou encore un équipement spécifique, peut être prévu, alternativement, notamment un autre équipement solidaire du module ou de l'installation photovoltaïque et mobile en translation relativement à celui-ci ou celle-ci.

Dans le cas où le robot nettoyeur est utilisé, ce dernier peut être déplacé sur le ou les modules photovoltaïques afin de participer au test de fonctionnement de la diode ou des diodes.

L'avantage d'utiliser le robot nettoyeur est que l'on peut mutualiser le nettoyage du ou des modules et le test de fonctionnement de la ou des diodes, ce dernier n'augmentant alors pas significativement le coût de maintenance.

L'étape b peut être mise en œuvre après un intervalle de temps après mise en œuvre de l'étape a, notamment après mise en dérivation, et/ou pendant un intervalle de temps, ledit intervalle de temps étant compris entre 10s et 80s.

Le robot peut être déplacé sur l'installation photovoltaïque à une vitesse choisie de manière à permettre une prise de mesure de température de ladite diode avant et après mise en dérivation de telle sorte à pouvoir constater une variation de température de ladite diode si celle-ci est en état fonctionnel. En particulier, le robot peut être déplacé sur l'installation photovoltaïque à une vitesse choisie de manière à permettre une prise de mesure de température de ladite diode avant mise en dérivation (seuil) et après mise en dérivation de telle sorte à pouvoir constater une variation de température de ladite diode entre ces deux moments si la diode est en état fonctionnel.

Une telle vitesse peut être uniforme tout au long du parcours du robot ou varier. Elle peut en particulier être nulle pendant une durée prédéterminée dans une, ou plusieurs, position(s) prédéterminée(s) du robot.

Le déplacement du robot peut être effectué de façon autonome ou télécommandée.

Au moment de la mise en dérivation d'une ou de plusieurs diodes, le robot peut être commandé pour marquer un temps d'arrêt en fonction de la rapidité d'apparition du point chaud au niveau de la ou des diodes, par exemple pendant une durée comprise entre 20 s et 80 s.

La mesure peut être effectuée pendant une durée supérieure à 10s, notamment supérieure à 20s, de manière à laisser un temps suffisant pour l'échauffement de la ou des diodes pour que la chaleur dégagée par celle-ci ou celles-ci diffuse en face avant du module, la ou les diodes étant disposées généralement sur la face arrière du module.

Au cours du procédé, une température dans au moins une zone, connexe à la diode, du module photovoltaïque peut être mesurée afin d'avoir une référence de température avant et/ou pendant la mesure de la température de la diode, après activation de celle-ci, pour surveiller si le module photovoltaïque lui-même ne change pas de température en raison d'une modification de l'irradiation reçue pendant la mesure.

Le module photovoltaïque peut être relié à un onduleur ou un micro-onduleur. Dans ce cas, la mise en dérivation peut être provoquée par l'onduleur ou le micro-onduleur, notamment lorsque la puissance maximale générée par ladite chaîne est inférieure à la puissance maximale générée par une chaîne adjacente du même module ou d'un module adjacent relié en série. Dans ce cas, l'onduleur ou le micro-onduleur fixe le point de fonctionnement électrique du système.

En effet, si un ombrage ou un défaut apparaît sur une cellule ou sur un groupe de cellules sur une même chaîne, la courbe I/V va se déformer et le point de puissance maximale, constitué par le produit tension par courant selon l'équation P=U*I, va changer. Si les ombrages ou défauts sont importants, le point de fonctionnement maximum se retrouve au niveau de la puissance maximale générée par une chaîne adjacente du même module ou d'un module adjacent relié en série, et cela correspond à un cas où la diode est activée. C'est ce cas de figure qui est provoqué par l'ombrage pour le déclenchement de la diode afin de pouvoir la tester.

Lorsqu'un micro-onduleur est présent, le micro-onduleur peut réaliser une optimisation module par module, de telle sorte que le déclenchement de la diode se produit quand la puissance maximale générée par la chaîne ou un groupe de chaînes avec ombrage est inférieure à la puissance maximale générée par une chaîne adjacente ou un groupe de chaînes adjacent du même module ou d'un module adjacent relié en série.

Lorsque le module photovoltaïque est relié à un onduleur, une pluralité de modules est branchée à l'onduleur, l'onduleur peut optimiser l'ensemble de ces modules. Dans ce cas, même avec un ombrage faible, la condition de la puissance maximale générée par la chaîne avec ombrage qui est inférieure à la puissance maximale générée par une chaîne adjacente du même module ou d'un module adjacent relié en série est généralement vérifiée puisque l'ensemble des modules adjacents fonctionnent correctement.

L'éclairement ambiant est de préférence supérieur à 200W/m², de préférence supérieur à 500W/m², lors de la mise en œuvre des étapes a et b du procédé et de préférence inférieur à 1000W/m². Une telle condition permet d'assurer que le ou les modules photovoltaïques soient en état de fonctionnement. La température ambiante est de préférence inférieure ou égale à 40°C lors de la mise en œuvre des étapes a et b du procédé. Si l'irradiance ne dépasse pas le seuil de 1000W/m² et que la température ambiante, c'est-à-dire extérieure, est inférieure à 40°C, cela permet que la chaleur qui sera dégagée par la ou les diodes testées ne soit pas masquée par la chaleur du module en fonctionnement.

Lorsque l'éclairement est insuffisant, en particulier de certaines cellules, le procédé peut comporter une étape, simultanée avec l'étape a, d'éclairement artificiel d'une partie des cellules pour permettre d'assurer que le ou les modules photovoltaïques soient en fonctionnement, notamment à l'aide d'un système d'éclairage.

Le procédé peut comporter une étape préalable à l'étape a d'ombrage consistant à effectuer une mesure de la température de la surface du module photovoltaïque où se situe la ou les diodes qui seront testées afin de déterminer la température initiale, cette mesure pouvant être effectuée à l'aide d'un capteur thermique, notamment d'une caméra thermique. Cette température peut constituer ledit seuil.

L'étape b peut être mise en œuvre à l'aide d'un capteur thermique, notamment d'une caméra thermique. Le procédé comporte alors de préférence une étape préalable de réglage du capteur thermique, notamment de la caméra thermique, par exemple en effectuant un test sur une diode de dérivation avant mise en œuvre des étapes a et b.

Le seuil indiqué à l'étape b du procédé peut correspondre à une mesure de température de la diode avant mise en dérivation, notamment juste avant mise en dérivation.

Le module photovoltaïque peut comporter une pluralité de chaînes de cellules photovoltaïques reliées en série, chaque chaîne étant reliée à une diode de dérivation qui lui est dédiée. Dans ce cas, les étapes a et b sont avantageusement mises en œuvre sur tout ou partie de ladite pluralité de chaînes de cellules.

Le robot nettoyeur a pour fonction initiale le nettoyage du ou des modules photovoltaïques. Il est apte à être déplacé sur le ou les modules photovoltaïques en étant solidaire de celui-ci ou de ceux-ci. Le robot est avantageusement équipé, pour la mise en œuvre du procédé, d'un système ombrageant et d'un capteur thermique, notamment d'une caméra thermique. Le robot peut encore être équipé d'un circuit de traitement pour la mise en œuvre de l'étape c, mettant par exemple en œuvre un algorithme de traitement des mesures afin de comparer la ou les mesures de température audit seuil et déterminer l'état de fonctionnement de la ou des diodes qui sont testées. Un tel circuit de traitement peut être en variante externe au robot, ce dernier étant apte à échanger des informations avec ledit circuit de traitement.

De préférence, l'étape a est mise en œuvre pour ombrager une partie seulement des cellules pour une chaîne donnée, une autre partie des cellules de ladite chaîne restant éclairée ou étant éclairée, par l'éclairement ambiant ou par un système d'éclairage artificiel.

Le procédé peut comporter, en amont de la mise en œuvre de l'étape a, une étape d'optimisation de la disposition d'un système ombrageant destiné à mettre en œuvre l'étape a, afin de susciter l'activation de la ou des diodes concernées. Cela peut permettre d'adapter le système ombrageant et sa disposition en fonction de la configuration de l'installation photovoltaïque et/ou du type de cellules des modules.

L'étape a peut être mise en œuvre de manière à ombrager le ou les modules photovoltaïques de façon symétrique entre les chaînes et/ou au sein d'une même chaîne. Un tel mode de réalisation peut consister à ombrager des cellules d'une chaîne de manière symétrique à l'aide de deux parties opaques du système ombrageant, une partie, par exemple centrale, des cellules n'étant pas ombragée, étant notamment disposée entre ces deux parties opaques. La partie des cellules non ombragée peut être recouverte par une partie, transparente ou avec une ouverture, du système ombrageant, notamment reliant les deux parties opaques. Un tel mode de réalisation peut en particulier convenir pour des modules photovoltaïques à demi-cellules avec deux chaînes de cellules en série avec une mutualisation des diodes de protection.

Le procédé peut comporter, avant mise en œuvre de l'étape a, une étape de calibration de l'ombrage. Une telle étape peut consister à adapter l'ombrage de telle sorte que la puissance maximale du module ombragé coïncide avec l'activation de la diode ou des diodes. Une telle étape peut être réalisée avec un système ombrageant adapté au(x) module(s) et un relevé des courbes I/V.

La mesure de la température à l'étape b peut être effectuée par un opérateur. Ce dernier peut par exemple réaliser la mesure de thermographie infrarouge à l'arrière du stand de modules pendant que le robot parcourt le ou les modules. Cela peut convenir en particulier pour de petites installations photovoltaïques.

Selon un autre aspect, en combinaison avec tout ou partie de ce qui précède, il est proposé un dispositif pour la mise en œuvre du procédé tel que défini plus haut, comportant au moins :
- un équipement, notamment autonome ou télécommandé, de préférence solidaire de l'installation photovoltaïque et pouvant se déplacer, notamment en translation relativement à celle-ci, l'équipement étant opaque pour ombrager au moins partiellement une partie des cellules d'au moins une chaîne d'au moins un module photovoltaïque de l'installation,
- un capteur thermique pour mesurer une température de la diode, et
- un circuit de traitement pour comparer la température de la diode avec un seuil et déduire de la comparaison un état de la diode.

Selon un autre aspect, en combinaison avec tout ou partie de ce qui précède, il est proposé un équipement d'un dispositif tel que défini plus haut, comportant un robot, notamment un robot nettoyeur du module photovoltaïque.

Dans ce cas, le robot peut comporter au moins une caméra thermique et au moins un système ombrageant constitué par au moins un volet rapporté sur le robot ou par le robot lui-même.

Le système ombrageant peut comporter une partie transparente et/ou ouverte afin de permettre à la lumière d'éclairer une partie des cellules photovoltaïques liées à la diode que l'on veut tester.

Le système ombrageant peut comporter un ou plusieurs volets comportant plusieurs, notamment deux, parties opaques reliées entre elles par une partie transparente, et par exemple disposées de manière symétrique. Dans ce cas, ladite partie transparente peut, dans un mode de réalisation particulier, comporter une ouverture et au moins deux bras reliant les parties opaques entre elles.

Le système ombrageant peut être détachable du robot et/ou mobile relativement à celui-ci.

Le volet du système ombrageant peut consister en un film ou une plaque opaque à la lumière. Il peut être disposé, lors de la mise en œuvre de l'étape a du procédé, devant, derrière ou sur un ou des côtés du robot.

Notamment dans le cas où c'est le robot lui-même qui fait ombrage, le dispositif peut comporter un système d'éclairage intégré et contrôlable de façon à éclairer une partie des cellules liées à la diode ou aux diodes que l'on veut tester. Cela permet qu'aucune chaîne de cellules dont on veut tester la diode ne soit entièrement ombragée, mais qu'il y ait une partie éclairée et une partie ombragée.

Le robot peut comporter un bras sur lequel le capteur thermique, notamment la caméra thermique, est fixé, de manière à lui permettre d'accéder à la face arrière du ou des modules logeant la ou les diodes, en particulier si la température ambiante est élevée et que le soleil chauffe de façon importante le ou les modules photovoltaïques auquel cas la chaleur des modules pourrait empêcher de détecter une surchauffe de la ou des diodes.

Le robot peut comporter un système d'éclairement intégré pour éclairer une partie des cellules et activer la ou les diodes, notamment lorsque l'éclairement ambiant est insuffisant.

En particulier lorsque les cellules photovoltaïques sont des couches minces, le système ombrageant peut être configuré en fonction de l'agencement des cellules pour garantir les conditions d'activation de la ou des diodes.

### Brève description des dessins

D'autres caractéristiques, détails et avantages apparaîtront à la lecture de la description détaillée ci-après, et à l'analyse des dessins annexés, sur lesquels :
[Fig. 1] montre schématiquement un exemple de module photovoltaïque sur lequel le procédé selon l'invention peut être mis en œuvre.
[Fig. 2] est un graphe illustrant des courbes d'intensité en fonction de la tension relevées sur un module photovoltaïque en fonction de la surface ombragée du module.
[Fig. 3] montre schématiquement un module photovoltaïque avec une chaîne de cellules ombragée à 25% permettant d'obtenir une des courbes de la figure 2.
[Fig. 4] montre schématiquement un module photovoltaïque avec une chaîne de cellules ombragée à 50% permettant d'obtenir une autre des courbes de la figure 2.
[Fig. 5] montre schématiquement un module photovoltaïque avec une chaîne de cellules ombragée à 75% permettant d'obtenir encore une autre des courbes de la figure 2.
[Fig. 6] est un graphe illustrant la courbe d'intensité en fonction de la tension relevée sur le module de la figure 5.
[Fig. 7] est un graphe illustrant la courbe de puissance en fonction de la tension relevée pour le module de la figure 5.
[Fig. 8] montre schématiquement en vue de dessus un module photovoltaïque sur lequel est mis en œuvre le procédé selon un mode de réalisation de l'invention.
[Fig. 9] montre schématiquement en coupe transversale le module photovoltaïque illustré sur la figure 8 lors de la mise en œuvre du procédé.
[Fig. 10] est une photographie d'une installation photovoltaïque sur laquelle est mis en œuvre le procédé selon l'invention.
[Fig. 11] est une vue de dessus schématique de modules photovoltaïques sur lesquels est mis en œuvre le procédé selon un mode de réalisation.
[Fig. 12] est une vue de dessus schématique de modules photovoltaïques sur lesquels est mis en œuvre le procédé selon un mode de réalisation.
[Fig. 13] est une vue de dessus schématique de modules photovoltaïques sur lesquels est mis en œuvre le procédé selon un mode de réalisation.
[Fig. 14] est une vue de dessus schématique de modules photovoltaïques sur lesquels est mis en œuvre le procédé selon un mode de réalisation.
[Fig. 15] est une vue de dessus schématique de modules photovoltaïques sur lesquels est mis en œuvre le procédé selon un mode de réalisation.
[Fig. 16] est une vue de dessus schématique de modules photovoltaïques sur lesquels est mis en œuvre le procédé selon un mode de réalisation.
[Fig. 17] est une vue de dessus schématique de modules photovoltaïques sur lesquels est mis en œuvre le procédé selon un mode de réalisation.
[Fig. 18] est une vue de dessus schématique des modules photovoltaïques de la figure 17 après avancement du robot.
[Fig. 19] est une vue de dessus schématique de modules photovoltaïques sur lesquels est mis en œuvre le procédé selon un mode de réalisation.
[Fig. 20] est une vue de dessus schématique des modules photovoltaïques de la figure 19 après avancement du robot.
[Fig. 21] est une vue de dessus schématique de modules photovoltaïques sur lesquels est mis en œuvre le procédé selon un mode de réalisation.
[Fig. 22] est une vue de dessus schématique des modules photovoltaïques de la figure 21 après avancement du robot.
[Fig. 23 est une vue de dessus schématique de modules photovoltaïques sur lesquels est mis en œuvre le procédé selon un mode de réalisation.
[Fig. 24] est une vue de dessus schématique de modules photovoltaïques sur lesquels est mis en œuvre le procédé selon un mode de réalisation.
[Fig. 25] est une vue de dessus schématique de modules photovoltaïques sur lesquels est mis en œuvre le procédé selon un mode de réalisation.
[Fig. 26] illustre de manière schématique et en perspective un exemple de dispositif selon un mode de réalisation comportant un robot nettoyeur pour la mise en œuvre du procédé selon l'invention.
[Fig. 27] illustre de manière schématique et en perspective le dispositif de la figure 26 avec le déploiement d'un système ombrageant.

### Description des modes de réalisation

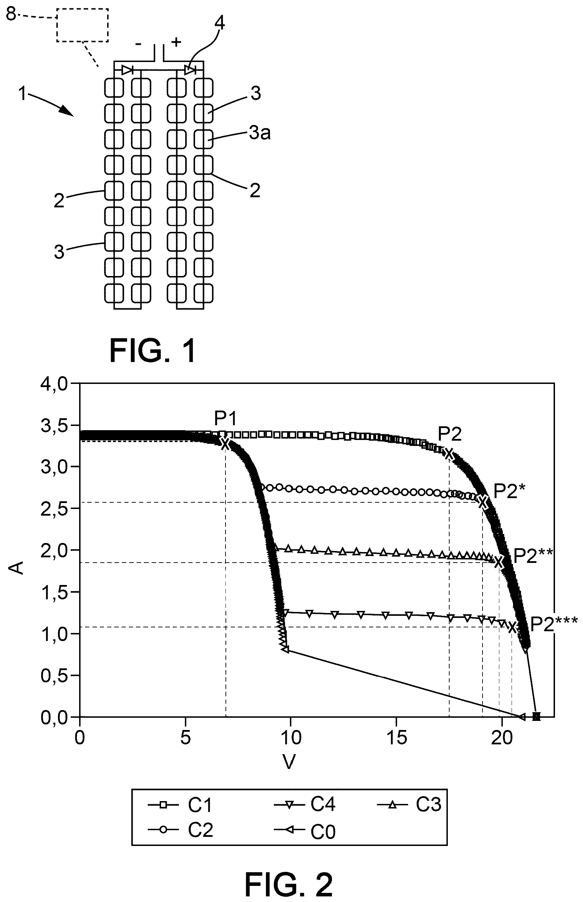

Il est maintenant fait référence à la figure 1. Sur cette figure, on a représenté schématiquement en vue de dessus un module photovoltaïque 1 comportant deux chaînes 2 comportant chacune une pluralité de cellules 3 photovoltaïques, au nombre de dix-huit cellules 3 pour chaque chaîne 2 dans cet exemple. Les cellules 3 sont reliées en série entre elles. La chaîne 2 illustrée sur la figure 1 comporte une cellule 3a qui a été ombragée. Une diode 4 de dérivation est associée à chacune des chaînes 2 de telle sorte que lorsqu'une ou plusieurs cellules 3 de la chaîne 2 sont ombragées, le courant ne circule plus dans les cellules 3 de la chaîne 2 mais au travers de la diode 4. La diode 4 est alors activée, devenant passante. Une mise en dérivation a été effectuée.

Le module 1 est relié dans cet exemple à un micro-onduleur 8. Lorsque les chaînes 2 ne sont pas ombragées, le micro-onduleur 8 sélectionne le point de puissance maximal P1 d'une chaîne 2 et P2 d'une chaîne adjacente, comme visible respectivement sur les courbes C0 et C1 illustrées sur la figure 2.

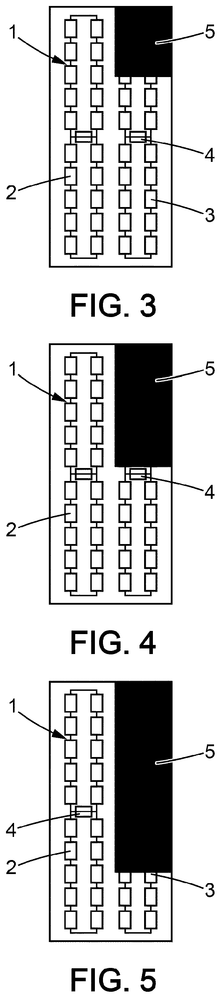

En revanche, si une partie de la chaîne 2 est ombragée par un système ombrageant 5 comme illustré sur les figures 3 à 5, alors la puissance diminue comme illustré sur les différentes courbes C2 à C4 de la figure 2. Ainsi P2* illustre le point de puissance maximal obtenu lorsque 25% de la surface des cellules 3 sont ombragées sur une chaîne 2 comme illustré sur la figure 3. P2** illustre le point de puissance maximal obtenu lorsque 50% des cellules 3 sont ombragées comme illustré sur la figure 4, tandis que P2*** illustre le point de puissance maximal obtenu lorsque 75% des cellules 3 sont ombragées comme illustré sur la figure 5.

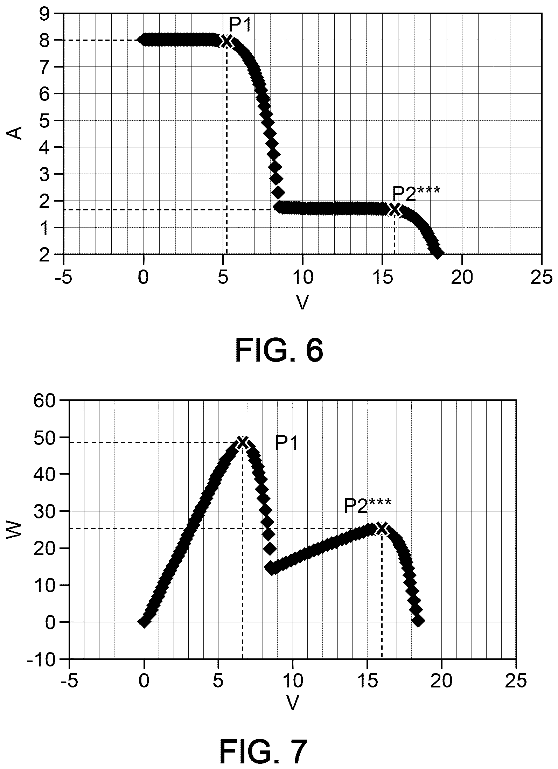

Les courbes illustrées sur les figures 6 et 7 représentent respectivement la courbe I/V du module illustré sur la figure 5 et la courbe puissance (en watt) en fonction de la tension (en volt) du même module illustré sur la figure 5.

Le micro-onduleur 8 est programmé pour déclencher la mise en dérivation c'est-à-dire activer la diode de dérivation 4 lorsque P1>P2 (P2 étant sous la forme P2, P2*, P2** ou P2*** en fonction de l'ombrage de la chaîne 2).

Le procédé selon l'invention utilise ces propriétés pour permettre la détection d'une diode défectueuse.

En effet, le procédé selon l'invention est un procédé de test d'au moins une diode de dérivation 4 sur une installation 100 photovoltaïque comportant au moins un module photovoltaïque 1 en fonctionnement, le module 1 photovoltaïque comportant au moins une chaîne 2 de cellules 3 photovoltaïques, en l'espèce trois chaînes 2 de vingt cellules 3 photovoltaïques, chacune étant reliée à une diode 4 de dérivation dédiée pour chaque chaîne 2.

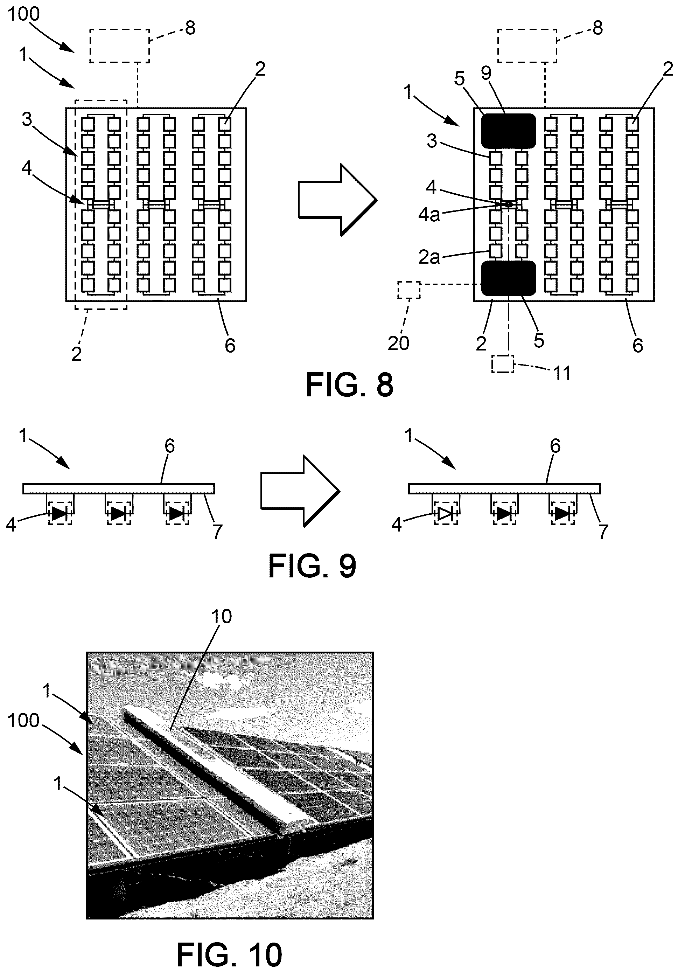

Comme visible sur la figure 8, le procédé comporte l'étape consistant à ombrager, à l'aide d'un système ombrageant 5, comportant deux volets 9 opaques dans cet exemple, au moins une partie des cellules 3 de la chaîne 2 jusqu'à provoquer une mise en dérivation au travers de la diode 4 dédiée à cette chaîne 2. La mise en dérivation provoque une augmentation de température de la diode 4 si la diode 4 est dans un état fonctionnel. Une telle mise en dérivation peut être déclenchée par le micro-onduleur 8. Le procédé comporte encore l'étape consistant à mesurer, notamment à l'aide d'un capteur thermique 11, au moins une température de la diode 4 et une étape consistant à comparer, notamment à l'aide d'un circuit de traitement 20, la température mesurée à un seuil pour en déduire un état de ladite diode 4, c'est-à-dire si la diode 4 est dans un état fonctionnel ou si elle est défectueuse.

Comme visible sur la figure 9, les diodes 4 sont situées dans cet exemple du côté de la face arrière 7 du module 1 photovoltaïque, la face avant 6 étant celle qui est visible sur la figure 8.

Le micro-onduleur 8 réalise une optimisation module par module, de telle sorte que le déclenchement de la diode 4 se produit quand la puissance maximale générée par la chaîne 2 avec ombrage est inférieure à la puissance maximale générée par une chaîne 2 adjacente du même module 1 ou d'un module 1 adjacent relié en série.

Dans l'exemple de la figure 8, l'installation 100 comporte un seul module 1 photovoltaïque.

Dans cet exemple, l'éclairement ambiant est supérieur à 200W/m lors de la mise en œuvre du procédé et inférieur à 1000W/m². Une telle condition permet d'assurer que le ou les modules 1 photovoltaïques soient en état de fonctionnement. La température ambiante est de préférence inférieure ou égale à 40°C lors de la mise en œuvre du procédé.

L'activation de la diode 4, si elle est en état fonctionnel, va générer un échauffement local qui sera détecté grâce à la mesure de la température et caractérisé par la comparaison au seuil.

Si la diode n'est pas en état fonctionnel, on ne pourra pas observer de variation de température à son niveau.

Si l'on mesure la température de la diode 4 dans le moment précédant la mise en dérivation, qui est l'instant où elle devient passante, et si cette température constituant le seuil est sensiblement égale à la température ambiante et qu'on n'observe pas de variation de la température de la diode 4 après mise en dérivation, alors on peut en conclure que la diode 4 est défectueuse, étant bloquée en circuit ouvert.

Si l'on compare la température de la diode 4, mesurée après mise en dérivation, au seuil correspondant à la température de la diode 4 mesurée dans le moment précédant la mise en dérivation, et si cette température constituant le seuil est supérieure à la température ambiante et qu'on n'observe pas de variation de la température de la diode après mise en dérivation, alors on peut en conclure que la diode est défectueuse, étant bloquée en court-circuit.

La détection d'une ou de plusieurs diodes 4 défectueuses peut permettre de prévenir d'éventuels risques de sécurité et/ou d'améliorer la production électrique de l'installation comportant une pluralité de modules photovoltaïques, c'est-à-dire la centrale photovoltaïque. De plus, d'autres défauts connexes tels qu'une ou des cellules photovoltaïques défectueuses peuvent être détectés à l'aide du procédé selon l'invention, notamment par la prise de mesures de températures.

Le procédé peut être mis en œuvre à l'aide d'un équipement, autonome ou télécommandé, configuré pour être solidaire de l'installation 100 photovoltaïque et pour se déplacer ou être déplacé relativement aux modules 1 de celle-ci. L'équipement peut être un robot, dans cet exemple un robot 10 nettoyeur de modules 1 photovoltaïques dont un exemple est illustré sur la figure 10. Un tel robot 10 nettoyeur, de manière connue en soi, est prévu pour effectuer périodiquement le nettoyage des modules 1 photovoltaïques de l'installation 100 photovoltaïque comportant une pluralité de modules 1 photovoltaïques sur cette figure 10. On peut utiliser de manière avantageuse le robot 10 nettoyeur pour la mise en œuvre du procédé selon l'invention. Cela permet de ne pas augmenter de manière significative les frais de maintenance, le robot 10 nettoyeur étant déjà utilisé pour la maintenance périodique des modules 1 photovoltaïques.

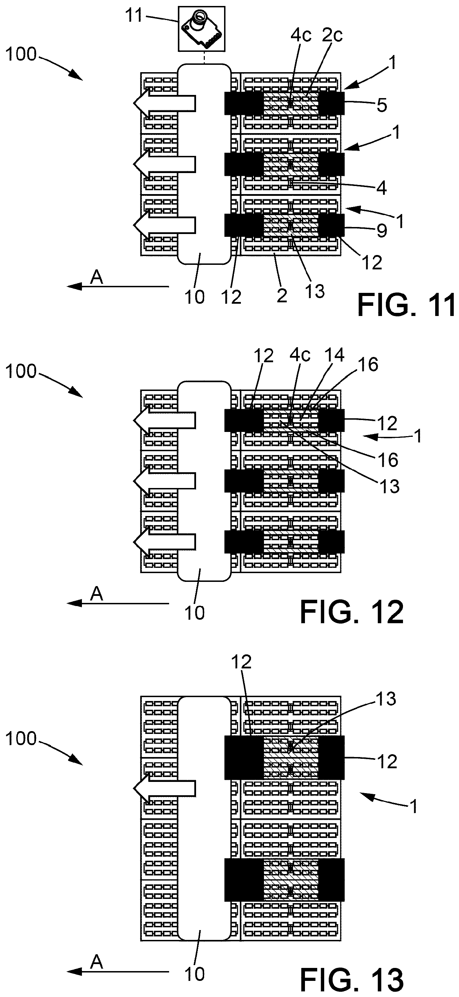

Dans l'exemple illustré sur les figures 11 à 16, l'installation 100 photovoltaïque comporte une pluralité de modules 1 photovoltaïques disposés côte-à-côte de bas en haut et latéralement. Le robot 10 couvre la surface de bas en haut de l'installation 100. Le robot 10 est déplacé selon la direction d'avancement A illustrée par les flèches sur ces figures. On a disposé à l'arrière du robot 10 nettoyeur, fixé à celui-ci, un système ombrageant 5 pour mettre en œuvre l'étape consistant à ombrager, à l'aide du système ombrageant 5, au moins une partie des cellules 3 d'une ou de plusieurs chaînes 2 jusqu'à provoquer une mise en dérivation au travers de chaque diode 4 dédiée à cette ou ces chaînes 2. Le robot 10 nettoyeur est également équipé d'un capteur thermique, constitué dans cet exemple par une caméra thermique 11, illustrée schématiquement uniquement sur la figure 11, mais présente dans l'ensemble de ces modes de réalisation des figures 11 à 16.

Une telle caméra thermique 11 permet de mettre en œuvre au moins l'étape consistant à mesurer au moins une température de la diode 4. Le robot 10 est par ailleurs configuré pour comparer la température mesurée à un seuil pour en déduire un état de la ou des diodes 4, c'est-à-dire si la diode 4 est dans un état fonctionnel ou si elle est défectueuse. En variante, le robot 10 est relié à un circuit de traitement qui permet de mettre en œuvre cette étape de comparaison de la température mesurée à un seuil pour en déduire un état de la ou des diodes 4.

Plus particulièrement, dans le mode de réalisation illustré sur la figure 11, l'installation 100 comporte, selon une direction transversale à la direction d'avancement A, trois modules photovoltaïques 1. Chaque module photovoltaïque 1 comporte trois chaînes 2 de vingt cellules 3 chacune, chacune comportant également une diode 4 de dérivation. Le robot 10 comporte un système ombrageant 5 comportant trois volets 9 comportant chacun une partie opaque 12 et une partie transparente 13, la partie opaque 12 étant scindée en deux parties de part et d'autre de la partie transparente 13. L'ombrage formé par les parties opaques 12 est symétrique dans cet exemple, ce qui peut permettre de contrôler plus précisément l'activation de la diode. Chaque volet 9 couvre une chaîne 2c centrale d'un module photovoltaïque 1, ombrageant avec les parties opaques 12 une partie de cette chaîne 2c centrale jusqu'à déclencher la mise en dérivation, et donc activer la diode 4c dédiée à la chaîne 2c centrale. La vitesse du robot 10 est adaptée pour permettre cette mise en dérivation, le robot 10 étant par exemple stoppé dans la position illustrée pendant une durée supérieure à 10s, par exemple supérieure à 20s, et inférieure à 80s. Cela permet d'activer les trois diodes 4c des chaînes 2c centrales des modules 1.

Le mode de réalisation de la figure 12 diffère de celui de la figure 11 en ce que la partie transparente 13 comporte une ouverture 14 formée entre deux bras 16 transparents reliant les deux parties opaques 12 entre elles. Cette ouverture 14 peut permettre de faciliter la détection de l'échauffement de la diode 4c.

Dans l'exemple de la figure 13, le nombre de modules photovoltaïques 1 de l'installation 100 est égal à quatre dans une direction transversale à la direction d'avancement A. Par ailleurs, le système ombrageant 5 comporte deux volets 9 comportant chacun une partie opaque 12 et une partie transparente 13, la partie opaque 12 étant scindée en deux parties de part et d'autre de la partie transparente 13. Chaque partie opaque 12 couvre deux portions de deux chaînes 2 adjacentes appartenant à deux modules 1 différents et adjacents. Ainsi, les deux volets 9 permettent d'activer simultanément quatre diodes 4 appartenant à quatre modules 1 différents. L'ombrage formé par les parties opaques 12 est symétrique dans cet exemple, ce qui peut permettre de contrôler plus précisément l'activation des diodes 4.

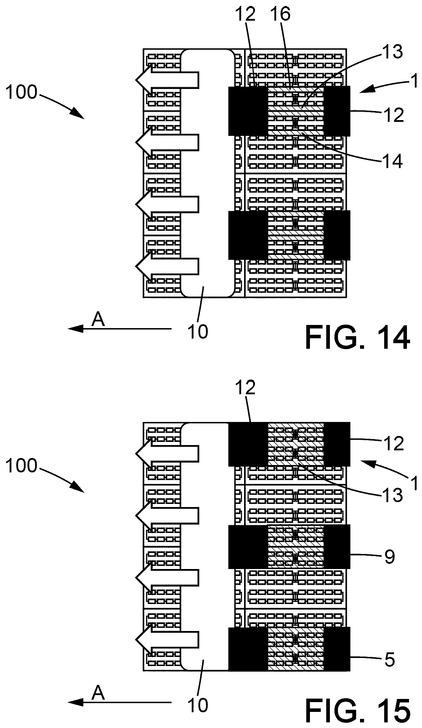

Le mode de réalisation de la figure 14 diffère de celui de la figure 13 en ce que la partie transparente 13 comporte deux ouvertures 14 formées entre deux bras 16 transparents reliant les deux parties opaques 12 entre elles. Ces ouvertures 14 peuvent permettre de faciliter la détection de l'échauffement des diodes 4 concernées.

Dans le mode de réalisation de la figure 15, illustrant une installation 100 similaire à celle de la figure 13 ou 14, le système ombrageant 5 comporte trois volets 9 couvrant chacun partiellement deux chaînes 2 adjacentes. Deux volets 9 couvrent chacun deux chaînes 2 adjacentes d'un même module 1, provoquant la mise en dérivation au travers de deux diodes 4 d'un même module 1, tandis que le volet 9 central couvre deux chaînes 2 adjacentes de deux modules 1 différents, provoquant la mise en dérivation au travers d'une seule des diodes 4 de chacun de ces modules 1.

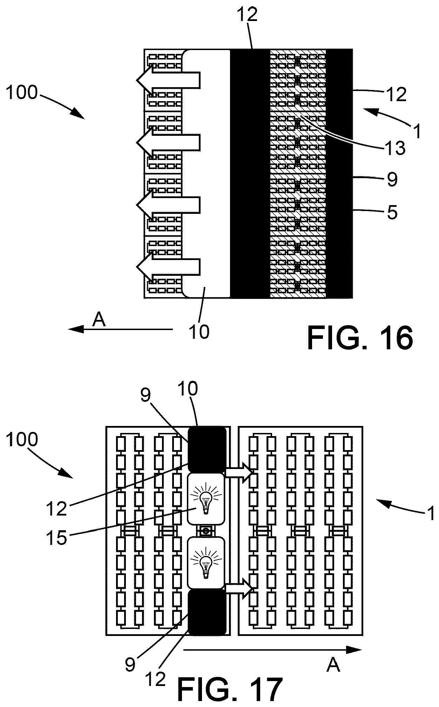

Le mode de réalisation de la figure 16 diffère de celui de la figure 15 en ce qu'il comporte un système ombrageant 5 couvrant la totalité de la largeur, transversale à la direction d'avancement A, du robot 10 et donc de l'installation 100. Le système ombrageant 5 comporte un unique volet 9 comportant une partie opaque 12 en deux parties entourant symétriquement une partie transparente 13 centrale. Toutes les diodes 4 de tous les modules 1 disposés de bas en haut de l'installation 100 sont ainsi activées simultanément et peuvent donc être testées simultanément.

Dans les modes de réalisation illustrés sur les figures 17 à 22, l'installation 100 comporte une succession de modules 1 photovoltaïques disposés côte-à-côte dans la direction d'avancement A du robot 10. Chaque module 1 comporte trois chaînes 2 de vingt cellules 3 chacune. Dans les modes de réalisation des figures 11 à 16, les chaînes 2 s'étendent parallèlement à la direction d'avancement A. Dans les modes de réalisation des figures 17 à 22, les chaînes 2 s'étendent transversalement, perpendiculairement, à cette direction d'avancement A.

Toujours dans ces exemples des figures 17 à 22, le robot 10 lui-même est le système ombrageant 5, ce dernier n'étant pas déployé hors du robot 10 mais étant constitué par une partie du robot. De plus, le robot nettoyeur 10 comporte un système d'éclairage 15 afin d'éclairer une partie des cellules ombragées et participer au déclenchement des diodes 4. Ce système d'éclairage 15 peut être utilisé pour combler un déficit d'éclairement. Dans le cas présent, il est plutôt utilisé pour compenser l'ombrage formé par une partie du robot 10 dans une zone de la chaîne 2 que l'on ne souhaite pas ombrager pour activer les diodes 4.

Dans l'exemple illustré sur la figure 17, le système ombrageant 5 comporte deux volets 9 opaques disposés de manière symétrique autour de la diode 4 d'une chaîne 2 d'un module 1. La partie de la chaîne 2 qui n'est pas prévue pour être ombragée est éclairée par le système d'éclairage 15 afin d'assurer que la diode 4 dédiée à cette chaîne 2 soit activée.

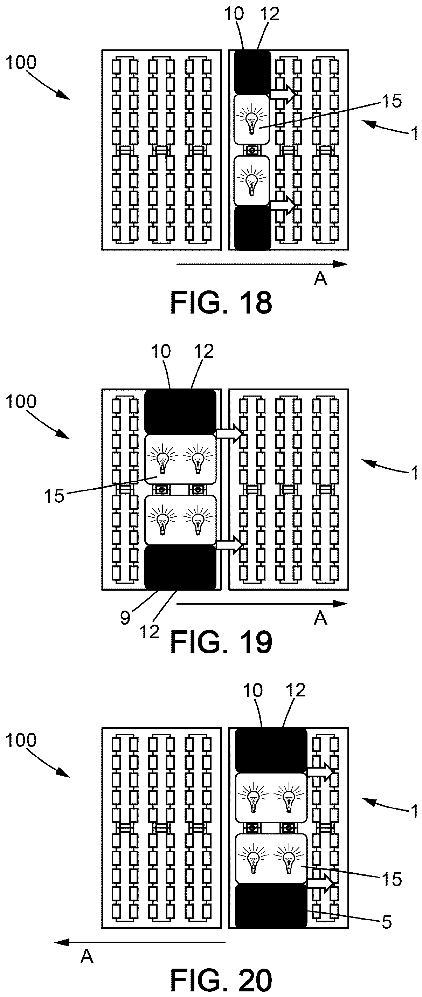

La figure 18 illustre le déplacement du robot 10 de la figure 17 à la chaîne 2 suivante du module 1 adjacent pour provoquer la mise en dérivation au travers de la diode 4 dédiée à cette chaîne 2 suivante, afin de vérifier son état.

Dans le mode de réalisation des figures 19 et 20, deux chaînes 2 adjacentes d'un module 1 sont concernées par la mise en œuvre du procédé selon l'invention, le robot 10 formant un système ombrageant 5 couvrant de manière symétrique deux parties des deux chaînes 2 de part et d'autre d'une partie centrale de celles-ci, ladite partie centrale étant éclairée par le système d'éclairage 15. Ainsi, deux diodes 4 dédiées auxdites chaînes 2 concernées peuvent être testées.

La figure 20 illustre le déplacement du robot nettoyeur 10 de la figure 19 aux deux chaînes 2 suivantes du module 1 adjacent pour provoquer la mise en dérivation au travers des diodes 4 dédiées à ces deux chaînes 2 suivantes, afin de vérifier leur état.

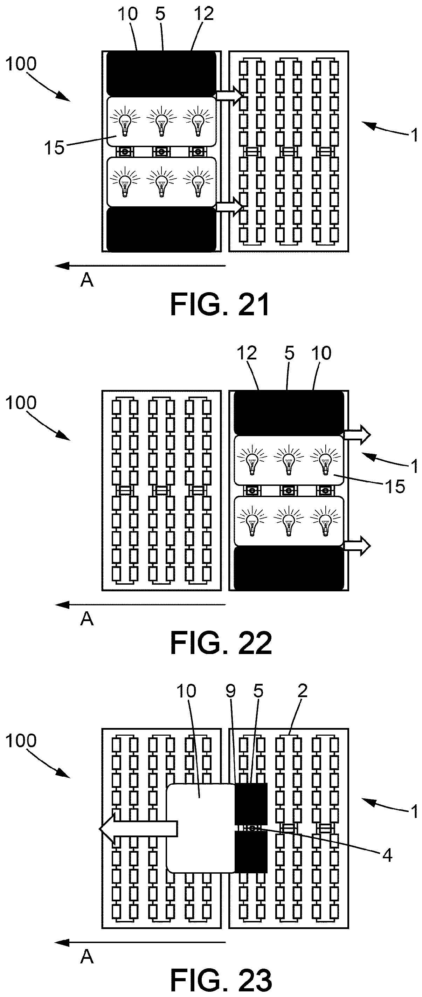

Dans le mode de réalisation des figures 21 et 22, les trois chaînes 2 d'un même module 1 sont concernées par la mise en œuvre du procédé selon l'invention, le robot 10 formant un système ombrageant 5 couvrant de manière symétrique deux parties des trois chaînes 2 de part et d'autre d'une partie centrale de celles-ci, ladite partie centrale étant éclairée par le système d'éclairage 15. Ainsi, les trois diodes 4 du module 1, dédiées auxdites chaînes 2 du module 1 sont testées.

La figure 22 illustre le déplacement du robot 10 de la figure 21 aux trois chaînes 2 suivantes du module 1 adjacent pour provoquer la mise en dérivation au travers des diodes 4 du module 1 adjacent, dédiées à ces trois chaînes 2, afin de vérifier leur état.

Dans les modes de réalisation illustrés sur les figures 23, 24 et 25, le robot 10 ne s'étend pas sur la totalité de la largeur, transversale à la direction d'avancement A, des modules 1 de l'installation 100. Par ailleurs, l'installation 100 comporte, comme dans celle des figures 17 à 22, un seul module 1 dans cette largeur. De plus, le système ombrageant 5 comporte deux volets 9 comportant chacun uniquement une partie opaque 12 qui se déploie à l'arrière du robot 10 pour ombrager une partie des cellules 3.

Dans le mode de réalisation de la figure 23, une partie, notamment la moitié, des cellules 3 d'une chaîne 2 est ombragée de manière à provoquer la mise en dérivation et donc l'activation de la diode 4 dédiée à cette chaîne 2.

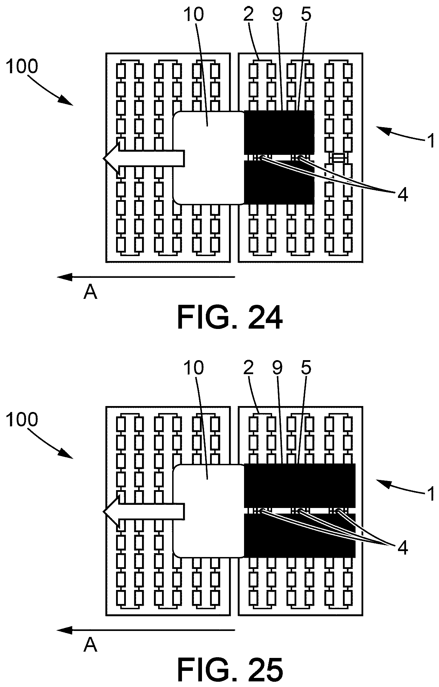

Dans le mode de réalisation de la figure 24, une partie, notamment la moitié, des cellules 3 de deux chaînes 2 adjacentes est ombragée de manière à provoquer la mise en dérivation et donc l'activation des deux diodes 4 associées à ces chaînes 2.

Enfin, dans le mode de réalisation de la figure 25, une partie, notamment la moitié, des cellules 3 des trois chaînes 2, c'est-à-dire de toutes les chaînes 2 du module 1 dans cet exemple, est ombragée de manière à provoquer la mise en dérivation et donc l'activation des trois diodes 4 du module 1.

L'activation de la ou des diodes 4 constitue la première étape avant de mesurer la température de la diode 4 ou des diodes 4 pour pouvoir la ou les comparer à un seuil et en déduire si la ou les diodes 4 sont dans un état fonctionnel ou non.

L'étape de la mesure de température(s) est avantageusement effectuée par le robot 10, lequel est équipé d'au moins un capteur thermique, notamment d'une caméra thermique 11. Une telle caméra thermique 11 est apte à mesurer la température de la diode 4 ou de plusieurs diodes 4, par exemple avant mise en dérivation et après mise en dérivation, et/ou de la surface du module, d'une température ambiante, etc.

L'étape de comparaison de la température mesurée à un seuil et de déduction de l'état de la diode 4 peut être effectuée par le robot 10 lui-même s'il est équipé d'un circuit de traitement ou par un circuit de traitement extérieur avec lequel le robot 10 peut communiquer pour échanger des informations.

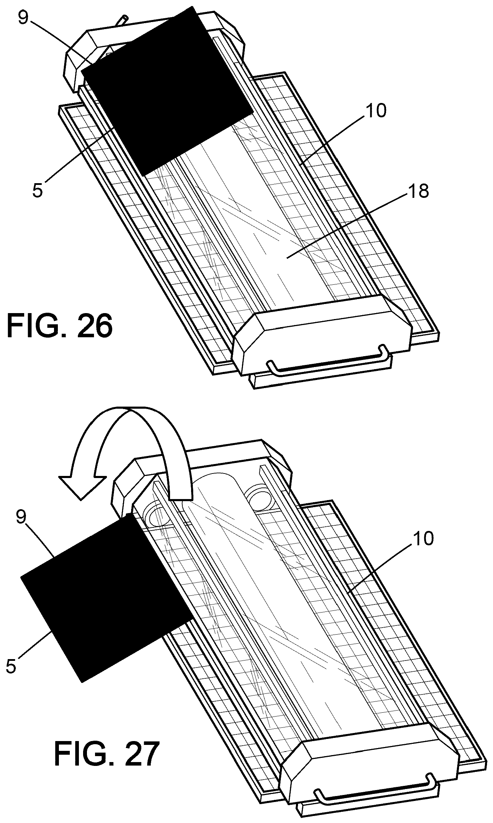

Dans le mode de réalisation illustré sur les figures 26 et 27, le robot 10 nettoyeur comporte un système ombrageant 5 constitué par un volet 9 mobile en rotation relativement au corps 18 du robot 10 afin de passer d'une position repliée illustrée sur la figure 26 à une position déployée illustrée sur la figure 27. Dans la position repliée, le système ombrageant 5 n'est pas apte à ombrager une partie des cellules 3, tandis que la position déployée permet de couvrir une partie des cellules 3 lorsque le robot 10 est fixé à une installation photovoltaïque 100 et/ou à au moins un module 1 photovoltaïque.

Bien entendu, l'invention n'est pas limitée aux exemples qui viennent d'être décrits.

Le robot peut être autonome ou télécommandé à distance.

Lorsqu'il y a plusieurs modules 1 photovoltaïques, la gestion de ceux-ci peut être effectuée par un onduleur à la place d'un micro-onduleur. Une pluralité de modules est alors branchée à l'onduleur. L'onduleur peut optimiser l'ensemble de ces modules. Dans ce cas, même avec un ombrage faible, la condition de la puissance maximale générée par la chaîne avec ombrage qui est inférieure à la puissance maximale générée par une chaîne adjacente du même module ou d'un module adjacent relié en série est généralement vérifiée puisque l'ensemble des modules adjacents fonctionnent correctement.

Tout autre robot ou équipement, du type organe autonome ou télécommandé, que le robot 10 nettoyeur, dédié ou non à la mise en œuvre du procédé, peut être utilisé dans l'invention.

Le procédé peut comporter une étape préalable à l'étape d'ombrage consistant à effectuer une mesure de la température de la surface 6 du module 1 photovoltaïque où se situe la ou les diodes 4 qui seront testées afin de déterminer la température initiale, cette mesure pouvant être effectuée à l'aide d'un capteur thermique, notamment d'une caméra thermique 11. Cette température peut constituer ledit seuil.

Le procédé peut comporter, avant ombrage, une étape de calibration de l'ombrage. Une telle étape peut consister à adapter l'ombrage de telle sorte que la puissance maximale du module 1 ombragé coïncide avec l'activation de la ou des diodes 4. Une telle étape peut être réalisée avec un système ombrageant 5 adapté au module 1 et un relevé des courbes I/V.

Au cours du procédé, une température dans au moins une zone connexe à la diode 4 du module 1 photovoltaïque peut être mesurée, par exemple en tant que seuil, afin d'avoir une référence de température avant et/ou pendant la mesure de la température de la diode 4, après activation de celle-ci, pour surveiller si le module 1 photovoltaïque lui-même ne change pas de température en raison d'une modification de l'irradiation reçue pendant la mesure.

L'étape de mesure de la température de la diode 4, après ombrage, peut être mise en œuvre à l'aide d'un capteur thermique, notamment d'une caméra thermique. Le procédé comporte alors de préférence une étape préalable de réglage du capteur thermique, notamment de la caméra thermique, par exemple en effectuant un test sur une diode 4 de dérivation avant mise en œuvre des étapes d'ombrage et de mesure de température de la diode 4.

## Revendications

1. Procédé de test d'au moins une diode (4) de dérivation sur une installation (100) photovoltaïque comportant au moins un module (1) photovoltaïque en fonctionnement, ledit module (1) photovoltaïque comportant au moins une chaîne (2) de cellules (3) photovoltaïques reliées à une diode (4) de dérivation dédiée à ladite chaîne (2), le procédé comportant:
a. ombrager une partie des cellules (3) de ladite chaîne (2) de manière à provoquer une mise en dérivation au travers de ladite diode (4), ladite mise en dérivation provoquant une augmentation de température de la diode (4) si la diode (4) est dans un état fonctionnel;
b. mesurer au moins une température de la diode (4) et
c. comparer la température mesurée à un seuil pour déduire un état de ladite diode (4).

2. Procédé selon la revendication 1, dans lequel au moins les étapes a et b sont mises en œuvre à l'aide d'un robot (10), notamment un robot nettoyeur de module photovoltaïque, ledit robot (10) étant configuré pour ombrager ladite partie des cellules (3) et comportant un capteur thermique, notamment une caméra thermique (11), pour mesurer ladite au moins une température de la diode (4).

3. Procédé selon la revendication 2, dans lequel le robot (10) est déplacé sur l'installation (100) photovoltaïque à une vitesse choisie de manière à permettre une prise de mesure de température de ladite diode (4) avant et après mise en dérivation de telle sorte à pouvoir constater une variation de température de ladite diode (4) si celle-ci est en état fonctionnel.

4. Procédé selon l'une quelconque des revendications précédentes, dans lequel ledit module (1) photovoltaïque est relié à un onduleur ou un micro-onduleur (8) et dans lequel la mise en dérivation est provoquée par l'onduleur ou le micro-onduleur (8), notamment lorsque la puissance maximale générée par ladite chaîne (2) est inférieure à la puissance maximale générée par une chaîne (2) adjacente du même module (1) ou d'un module (1) adjacent relié en série.

5. Procédé selon l'une quelconque des revendications précédentes, dans lequel l'éclairement ambiant est supérieur à 200W/m², et de préférence inférieur à 1000W/m², lors de la mise en œuvre des étapes a et b du procédé et dans lequel la température ambiante est de préférence inférieure ou égale à 40°C lors de la mise en œuvre des étapes a et b du procédé.

6. Procédé selon l'une quelconque des revendications précédentes, l'étape b étant mise en œuvre à l'aide d'un capteur thermique, notamment d'une caméra thermique (11), le procédé comportant une étape préalable de réglage du capteur thermique, notamment de la caméra thermique (11), notamment en effectuant un test sur une diode (4) de dérivation avant mise en œuvre des étapes a et b.

7. Procédé selon l'une quelconque des revendications précédentes, dans lequel ledit seuil correspond à une mesure de température de la diode (4) avant mise en dérivation.

8. Procédé selon l'une quelconque des revendications précédentes, ledit module (1) photovoltaïque comportant une pluralité de chaînes (2) de cellules (3) photovoltaïques reliées en série, chaque chaîne (2) étant reliée à une diode (4) de dérivation qui lui est dédiée, dans lequel les étapes a et b sont mises en œuvre sur tout ou partie de ladite pluralité de chaînes (2) de cellules (3).

9. Dispositif pour la mise en œuvre du procédé selon l'une quelconque des revendications précédentes, comportant au moins :
- un équipement opaque pour ombrager au moins partiellement une partie des cellules (3) d'au moins une chaîne (2) d'au moins un module (1) photovoltaïque de l'installation (100) photovoltaïque,
- un capteur thermique pour mesurer une température de la diode (4), et
- un circuit de traitement pour comparer la température de la diode (4) avec un seuil et déduire de la comparaison un état de la diode (4).

10. Equipement d'un dispositif selon la revendication 9, comportant un robot (10), notamment un robot nettoyeur du module (1) photovoltaïque.

11. Equipement selon la revendication 10, dans lequel le robot (10) comporte au moins une caméra thermique (11) et au moins un système ombrageant (5) constitué par au moins un volet (9) rapporté sur le robot (10) ou par le robot (10) lui-même.

## Patentansprüche

1. Verfahren zum Testen mindestens einer Bypass-Diode (4) auf einer Photovoltaikanlage (100), die mindestens ein in Betrieb befindliches Photovoltaikmodul (1) umfasst, wobei das Photovoltaikmodul (1) mindestens einen Strang (2) von photovoltaischen Zellen (3) aufweist, die mit einer dem Strang (2) zugeordneten Bypass-Diode (4) verbunden sind, wobei das Verfahren Folgendes umfasst:
a. Abschatten eines Teils der Zellen (3) des Strangs (2), um eine Überbrückung durch die Diode (4) zu bewirken, wobei die Überbrückung eine Erhöhung der Temperatur der Diode (4) bewirkt, wenn sich die Diode (4) in einem funktionsfähigen Zustand befindet;
b. Messen mindestens einer Temperatur der Diode (4) und
c. Vergleichen der gemessenen Temperatur mit einem Schwellenwert, um auf einen Zustand der Diode (4) zu schließen.

2. Verfahren nach Anspruch 1, bei dem zumindest die Schritte a und b mithilfe eines Roboters (10), insbesondere eines Reinigungsroboters für ein Photovoltaikmodul, durchgeführt werden, wobei der Roboter (10) so konfiguriert ist, dass er den Teil der Zellen (3) abschattet, und einen thermischen Sensor, insbesondere eine Wärmebildkamera (11), aufweist, um die mindestens eine Temperatur der Diode (4) zu messen.

3. Verfahren nach Anspruch 2, bei dem der Roboter (10) auf der Photovoltaikanlage (100) mit einer Geschwindigkeit bewegt wird, die so gewählt ist, dass eine Temperaturmessung der Diode (4) vor und nach der Überbrückung ermöglicht wird, so dass eine Temperaturänderung der Diode (4) festgestellt werden kann, wenn sich diese in einem funktionsfähigen Zustand befindet.

4. Verfahren nach einem der vorhergehenden Ansprüche, bei dem das Photovoltaikmodul (1) mit einem Wechselrichter oder einem Mikrowechselrichter (8) verbunden ist und bei dem die Überbrückung durch den Wechselrichter oder den Mikrowechselrichter (8) hervorgerufen wird, insbesondere wenn die von dem Strang (2) erzeugte maximale Leistung geringer ist als die maximale Leistung, die von einem benachbarten Strang (2) desselben Moduls (1) oder eines benachbarten, in Reihe geschalteten Moduls (1) erzeugt wird.

5. Verfahren nach einem der vorhergehenden Ansprüche, bei dem die Umgebungsbestrahlungsstärke bei der Durchführung der Schritte a und b des Verfahrens größer als 200 W/m² und vorzugsweise kleiner als 1000 W/m² ist, und bei dem die Umgebungstemperatur bei der Durchführung der Schritte a und b des Verfahrens vorzugsweise kleiner oder gleich 40 °C ist.

6. Verfahren nach einem der vorhergehenden Ansprüche, wobei Schritt b mithilfe eines thermischen Sensors, insbesondere einer Wärmebildkamera (11), durchgeführt wird, wobei das Verfahren einen vorherigen Schritt des Einstellens des thermischen Sensors, insbesondere der Wärmebildkamera (11), umfasst, insbesondere durch Durchführen eines Tests an einer Bypass-Diode (4) vor der Durchführung des Schritte a und b.

7. Verfahren nach einem der vorhergehenden Ansprüche, bei dem der Schwellenwert einer Temperaturmessung der Diode (4) vor der Überbrückung entspricht.

8. Verfahren nach einem der vorhergehenden Ansprüche, wobei das Photovoltaikmodul (1) eine Vielzahl von in Reihe geschalteten Strängen (2) von photovoltaischen Zellen (3) aufweist, wobei jeder Strang (2) mit einer ihm zugeordneten Bypass-Diode (4) verbunden ist, bei dem die Schritte a und b an allen oder einem Teil der Vielzahl von Strängen (2) von Zellen (3) durchgeführt werden.

9. Vorrichtung zur Durchführung des Verfahrens nach einem der vorhergehenden Ansprüche, umfassend mindestens:
- eine undurchsichtige Einrichtung zum zumindest teilweisen Abschatten eines Teils der Zellen (3) mindestens eines Strangs (2) mindestens eines Photovoltaikmoduls (1) der Photovoltaikanlage (100),
- einen thermischen Sensor zum Messen einer Temperatur der Diode (4), und
- eine Verarbeitungsschaltung zum Vergleichen der Temperatur der Diode (4) mit einem Schwellenwert und zum Ableiten eines Zustands der Diode (4) aus dem Vergleich.

10. Ausrüstung einer Vorrichtung nach Anspruch 9, umfassend einen Roboter (10), insbesondere einen Reinigungsroboter des Photovoltaikmoduls (1).

11. Ausrüstung nach Anspruch 10, bei der der Roboter (10) mindestens eine Wärmebildkamera (11) und mindestens ein Beschattungssystem (5) aufweist, das aus mindestens einer am Roboter (10) angebrachten Blende (9) oder durch den Roboter (10) selbst gebildet ist.

## Claims

1. Method for testing at least one bypass diode (4) on a photovoltaic installation (100) comprising at least one operating photovoltaic module (1), said photovoltaic module (1) comprising at least one string (2) of photovoltaic cells (3) connected to a bypass diode (4) dedicated to said string (2), the method comprising:
a. shading a portion of the cells (3) of said string (2) so as to cause a bypassing through said diode (4), said bypassing causing an increase in temperature of the diode (4) if the diode (4) is in a functional state;
b. measuring at least one temperature of the diode (4) and
c. comparing the measured temperature with a threshold to deduce a state of said diode (4).

2. Method according to claim 1, wherein at least steps a and b are implemented by means of a robot (10), in particular a cleaning robot of a photovoltaic module, said robot (10) being configured to shade said portion of the cells (3) and comprising a thermal sensor, in particular a thermal camera (11), for measuring said at least one temperature of the diode (4).

3. Method according to claim 2, wherein the robot (10) is moved over the photovoltaic installation (100) at a speed selected so as to allow a temperature measurement of said diode (4) to be taken before and after bypassing, so as to be able to observe a temperature variation of said diode (4) if the latter is in a functional state.

4. Method according to any one of the preceding claims, wherein said photovoltaic module (1) is connected to an inverter or a micro-inverter (8) and wherein the bypassing is caused by the inverter or the micro-inverter (8), in particular when the maximum power generated by said string (2) is lower than the maximum power generated by an adjacent string (2) of the same module (1) or of an adjacent module (1) connected in series.

5. Method according to any one of the preceding claims, wherein the ambient irradiance is greater than 200 W/m², and preferably less than 1000 W/m², during the implementation of steps a and b of the method, and wherein the ambient temperature is preferably less than or equal to 40 °C during the implementation of steps a and b of the method.

6. Method according to any one of the preceding claims, step b being implemented by means of a thermal sensor, in particular a thermal camera (11), the method comprising a preliminary step of adjusting the thermal sensor, in particular the thermal camera (11), in particular by performing a test on a bypass diode (4) before implementing steps a and b.

7. Method according to any one of the preceding claims, wherein said threshold corresponds to a temperature measurement of the diode (4) before bypassing.

8. Method according to any one of the preceding claims, said photovoltaic module (1) comprising a plurality of strings (2) of photovoltaic cells (3) connected in series, each string (2) being connected to a bypass diode (4) dedicated thereto, wherein steps a and b are implemented on all or part of said plurality of strings (2) of cells (3).

9. Device for implementing the method according to any one of the preceding claims, comprising at least:
- an opaque equipment for at least partially shading a portion of the cells (3) of at least one string (2) of at least one photovoltaic module (1) of the photovoltaic installation (100),
- a thermal sensor for measuring a temperature of the diode (4), and
- a processing circuit for comparing the temperature of the diode (4) with a threshold and deducing from the comparison a state of the diode (4).

10. Equipment of a device according to claim 9, comprising a robot (10), in particular a cleaning robot of the photovoltaic module (1).

11. Equipment according to claim 10, wherein the robot (10) comprises at least one thermal camera (11) and at least one shading system (5) consisting of at least one flap (9) attached to the robot (10) or by the robot (10) itself.
